# EUROPEAN PATENT APPLICATION

(11) **EP 3 447 581 A1**
(43) Date of publication of application: **27.02.2019**
(21) Application number: 17187611.3
(22) Date of filing: 23.08.2017
(51) Int. Cl.: G03F 7/20

(54) **A CLEAR-OUT TOOL, A LITHOGRAPHIC APPARATUS AND A DEVICE MANUFACTURING METHOD**

(71) Applicant: ASML Netherlands B.V., 5500 AH Veldhoven (NL)
(72) Inventor: HUANG, Yang-Shan, 5500 AH Veldhoven (NL); VORONINA, Victoria, 5500 AH Veldhoven (NL); JEUNINK, Andre, Bernardus, 5500 AH Veldhoven (NL); VAN DE VEN, Bastiaan, Lambertus, Wilhelmus, Marinus, 5500 AH Veldhoven (NL)
(74) Representative: Peters, John Antoine

(57) **Abstract**

A clear-out tool is described, the clear-out tool being configured to at least partially remove a masking layer from a target area of an object using a laser beam. The clear-out tool comprising a barrier member configured to contain a liquid in a space next to the target area or surrounding the target area.

## Description

### Field

The present invention relates to a clear-out tool as can be used to facilitate the operation of a lithographic apparatus, a lithographic apparatus, a method of processing a substrate and a method of operating a lithographic apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. In an embodiment, the liquid is distilled water, although another liquid can be used. An embodiment of the invention will be described with reference to liquid. However, another fluid may be suitable, particularly a wetting fluid, an incompressible fluid and/or a fluid with higher refractive index than air, desirably a higher refractive index than water. Fluids excluding gases are particularly desirable. The point of this is to enable imaging of smaller features since the exposure radiation will have a shorter wavelength in the liquid. (The effect of the liquid may also be regarded as increasing the effective numerical aperture (NA) of the system and also increasing the depth of focus.) Other immersion liquids have been proposed, including water with solid particles (e.g. quartz) suspended therein, or a liquid with a nano-particle suspension (e.g. particles with a maximum dimension of up to 10 nm). The suspended particles may or may not have a similar or the same refractive index as the liquid in which they are suspended. Other liquids which may be suitable include a hydrocarbon, such as an aromatic, a fluorohydrocarbon, and/or an aqueous solution.

Submersing the substrate or substrate and substrate table in a bath of liquid (see, for example, United States patent no. 4,509,852) means that there is a large body of liquid that must be accelerated during a scanning exposure. This requires additional or more powerful motors and turbulence in the liquid may lead to undesirable and unpredictable effects.

In an immersion apparatus, immersion fluid is handled by a liquid handling system, device structure or apparatus. In an embodiment the liquid handling system may supply immersion fluid and therefore be a fluid supply system. In an embodiment the liquid handling system may at least partly confine immersion fluid and thereby be a fluid confinement system. In an embodiment the liquid handling system may provide a barrier to immersion fluid and thereby be a barrier member, such as a fluid confinement structure. In an embodiment the liquid handling system may create or use a flow of gas, for example to help in controlling the flow and/or the position of the immersion fluid. The flow of gas may form a seal to confine the immersion fluid so the fluid handling structure may be referred to as a seal member; such a seal member may be a fluid confinement structure. In an embodiment, immersion liquid is used as the immersion fluid. In that case the liquid handling system may be a liquid handling system. In reference to the aforementioned description, reference in this paragraph to a feature defined with respect to fluid may be understood to include a feature defined with respect to liquid.

The patterning process as performed by a lithographic apparatus is repeated a plurality of times, thereby generating semiconductor structures that consist of different layers, e.g. having different structures. For a proper operation of the semiconductor device, a patterned beam of radiation, used to pattern a resist layer as applied on the substrate, needs to be properly aligned with a previously applied pattern. To align pattern on different layers, an alignment sensor detects the position of alignment marks on previous layer with optical method. However, in some cases, the applied resist layer which is also applied on top of the alignment marks, may obscure the alignment mark. As a result, it may be difficult for an alignment sensor to determine an accurate position of the alignment mark. In order to facilitate the detection of alignment marks that are covered by a resist layer, it has been proposed to use a laser to at least partially remove the resist layer in the area where the alignment mark is present. Such laser ablation processes may however cause debris or particles during the ablation process. Such particles or debris may be difficult to remove from the substrate and may subsequently adversely affect the exposure process as performed by the lithographic apparatus.

### Summary

It is desirable to provide in a clear-out tool whereby the generated debris is more easily contained or removed.

According to an aspect of the present invention, there is provided a clear-out tool configured to at least partially remove a masking layer from a target area of an object using a laser beam, the clear-out tool comprising a barrier member configured to contain a liquid in a space next to the target area or surrounding the target area.

According to another aspect of the present invention, there is provided a lithographic apparatus comprising:
- an illumination system configured to condition a radiation beam;
- a support constructed to support a patterning device, the patterning device being capable of imparting the radiation beam with a pattern in its cross-section to form a patterned radiation beam
- a substrate table constructed to hold a substrate; and
- a projection system configured to project the patterned radiation beam onto a target portion of the substrate,
wherein the apparatus further comprises a clear-out tool according to the invention.

According to another aspect of the present invention, there is provided a lithographic apparatus comprising:
- an illumination system configured to condition a radiation beam;
- a support constructed to support a patterning device, the patterning device being capable of imparting the radiation beam with a pattern in its cross-section to form a patterned radiation beam
- a substrate table constructed to hold a substrate; and
- a projection system configured to project the patterned radiation beam onto a target portion of the substrate,
a liquid handling system for containing a liquid in a space between a final element of the projection system and the substrate, and wherein the apparatus is configured to at least partially remove a masking layer from a target area of the substrate by projecting a laser beam via the projection system onto the target area, the liquid handling system being configured to contain the liquid in a space next to the target area or surrounding the target area.

According to another aspect of the present invention, there is provided a device manufacturing method comprising projecting a patterned beam of radiation onto a substrate, wherein the step of projecting a patterned beam of radiation onto a substrate is applied before or after a step of at least partly removing a masking layer from a target area on the substrate using a clear-out tool according to the present invention.

### Brief Description of the Drawings

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention.
Figures 2 and 3 depict a liquid supply system for use in a lithographic projection apparatus.
Figure 4 depicts a further liquid supply system for use in a lithographic projection apparatus.
Figure 5 depicts a further liquid supply system for use in a lithographic projection apparatus.
Figure 6 depicts a plan view of a liquid supply system for use in a lithographic projection apparatus.
Figure 7 depicts, in cross-section at line VII-VII in Figure 6, the liquid supply system of Figure 6.
Figure 8 schematically shows a clear-out tool according to an embodiment of the present invention.
Figure 9 schematically shows a top view of two possible barrier members of a clear-out tool according to the present invention.
Figures 10 and 11 schematically show clear-out tools according to embodiments of the present invention.
Figure 12 schematically shows a cross-sectional view of a seal as can be applied in a clear-out tool according to the present invention.
Figure 13 schematically shows a clear-out tool according to another embodiment of the present invention.

### Detailed Description

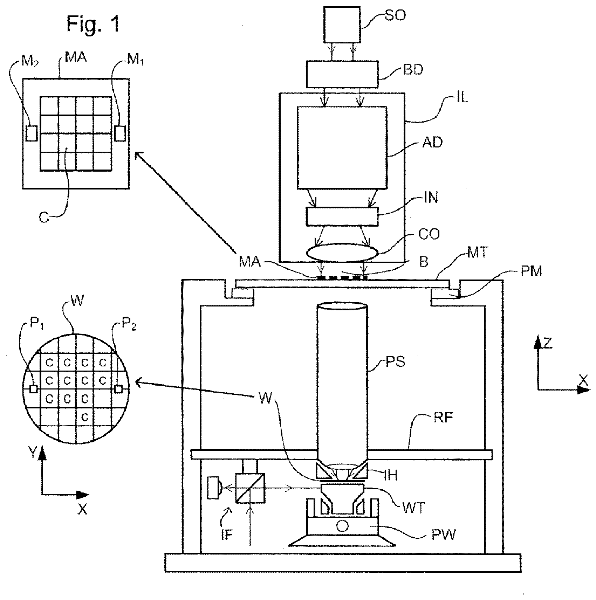

Figure 1 schematically depicts a lithographic apparatus according to one embodiment of the invention. The apparatus comprises:
- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device MA in accordance with certain parameters;
- a support table, e.g. a sensor table to support one or more sensors or a substrate table WT constructed to hold a substrate (e.g. a resist-coated substrate) W, connected to a second positioner PW configured to accurately position the surface of the table, for example of a substrate W, in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT holds the patterning device MA. It holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two or more tables (or stage or support), e.g., two or more substrate tables or a combination of one or more substrate tables and one or more sensor or measurement tables. In such "multiple stage" machines the multiple tables may be used in parallel, or preparatory steps may be carried out on one or more tables while one or more other tables are being used for exposure. The lithographic apparatus may have two or more patterning device tables (or stages or support) which may be used in parallel in a similar manner to substrate, sensor and measurement tables.

Referring to Figure 1, the illuminator IL receives a radiation beam from a radiation source SO. The source SO and the lithographic apparatus may be separate entities, for example when the source SO is an excimer laser. In such cases, the source SO is not considered to form part of the lithographic apparatus and the radiation beam is passed from the source SO to the illuminator IL with the aid of a beam delivery system BD comprising, for example, suitable directing mirrors and/or a beam expander. In other cases the source SO may be an integral part of the lithographic apparatus, for example when the source SO is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator IL can be adjusted. In addition, the illuminator IL may comprise various other components, such as an integrator IN and a condenser CO. The illuminator IL may be used to condition the radiation beam, to have a desired uniformity and intensity distribution in its cross-section. Similar to the source SO, the illuminator IL may or may not be considered to form part of the lithographic apparatus. For example, the illuminator IL may be an integral part of the lithographic apparatus or may be a separate entity from the lithographic apparatus. In the latter case, the lithographic apparatus may be configured to allow the illuminator IL to be mounted thereon. Optionally, the illuminator IL is detachable and may be separately provided (for example, by the lithographic apparatus manufacturer or another supplier).

The radiation beam B is incident on the patterning device (e.g., mask) MA, which is held on the support structure (e.g., mask table) MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks PI, P2. Although the substrate alignment marks as illustrated occupy dedicated target portions, they may be located in spaces between target portions C (these are known as scribe-lane alignment marks). Similarly, in situations in which more than one die is provided on the patterning device MA, the patterning device alignment marks may be located between the dies.

The depicted apparatus could be used in at least one of the following modes:
1. In step mode, the support structure MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the support structure MT and the substrate table WT are scanned synchronously while a pattern imparted to the radiation beam B is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion C in a single dynamic exposure, whereas the length of the scanning motion determines the height (in the scanning direction) of the target portion C.
3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Although specific reference may be made in this text to the use of lithographic apparatus in the manufacture of ICs, it should be understood that the lithographic apparatus described herein may have other applications in manufacturing components with microscale, or even nanoscale, features, such as the manufacture of integrated optical systems, guidance and detection patterns for magnetic domain memories, flat-panel displays, liquid-crystal displays (LCDs), thin-film magnetic heads, etc.

Arrangements for providing liquid between a final element of the projection system PS and the substrate can be classed into three general categories. These are the bath type arrangement, the so-called localized immersion system and the all-wet immersion system. In a bath type arrangement substantially the whole of the substrate W and optionally part of the substrate table WT is submersed in a bath of liquid.

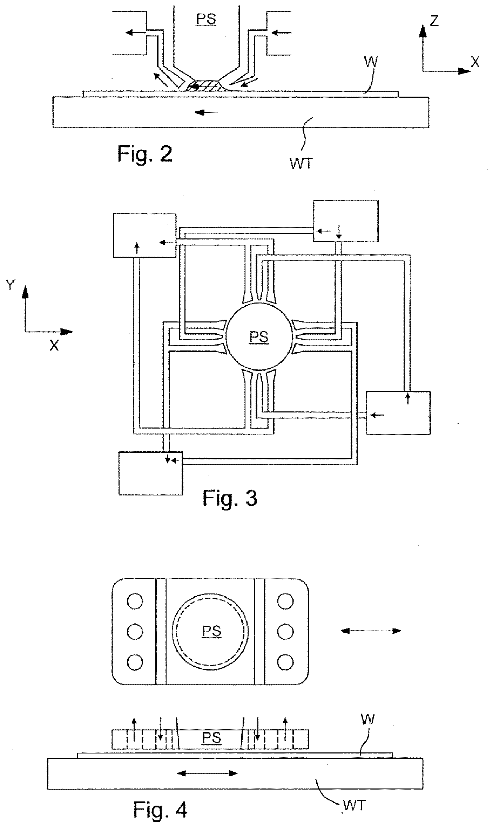

A localized immersion system uses a liquid supply system in which liquid is only provided to a localized area of the substrate. The space filled by liquid is smaller in plan than the top surface of the substrate and the area filled with liquid remains substantially stationary relative to the projection system PS while the substrate W moves underneath that area. Figures 2-5 show different supply devices which can be used in such a system. A sealing feature is present to substantially seal liquid to the localized area. One way which has been proposed to arrange for this is disclosed in PCT patent application publication no. WO 99/49504.

In an all wet arrangement the liquid is unconfined. The whole top surface of the substrate and all or part of the substrate table is covered in immersion liquid. The depth of the liquid covering at least the substrate is small. The liquid may be a film, such as a thin film, of liquid on the substrate. Immersion liquid may be supplied to or in the region of a projection system and a facing surface facing the projection system (such a facing surface may be the surface of a substrate and/or a substrate table). Any of the liquid supply devices of Figures 2-5 can also be used in such a system. However, a sealing feature is not present, not activated, not as efficient as normal or otherwise ineffective to seal liquid to only the localized area.

As illustrated in Figures 2 and 3, liquid is supplied by at least one inlet onto the substrate, desirably along the direction of movement of the substrate relative to the final element. Liquid is removed by at least one outlet after having passed under the projection system. As the substrate is scanned beneath the element in a -X direction, liquid is supplied at the +X side of the element and taken up at the -X side. Figure 2 shows the arrangement schematically in which liquid is supplied via inlet and is taken up on the other side of the element by outlet which is connected to a low pressure source. In the illustration of Figure 2 the liquid is supplied along the direction of movement of the substrate relative to the final element, though this does not need to be the case. Various orientations and numbers of in- and out-lets positioned around the final element are possible; one example is illustrated in Figure 3 in which four sets of an inlet with an outlet on either side are provided in a regular pattern around the final element. Note that the direction of flow of the liquid is shown by arrows in Figures 2 and 3.

A further immersion lithography solution with a localized liquid supply system is shown in Figure 4. Liquid is supplied by two groove inlets on either side of the projection system PS and is removed by a plurality of discrete outlets arranged radially outwardly of the inlets. The inlets can be arranged in a plate with a hole in its centre and through which the projection beam is projected. Liquid is supplied by one groove inlet on one side of the projection system PS and removed by a plurality of discrete outlets on the other side of the projection system PS, causing a flow of a thin film of liquid between the projection system PS and the substrate W. The choice of which combination of inlet and outlets to use can depend on the direction of movement of the substrate W (the other combination of inlet and outlets being inactive). Note that the direction of flow of fluid and of the substrate is shown by arrows in Figure 4.

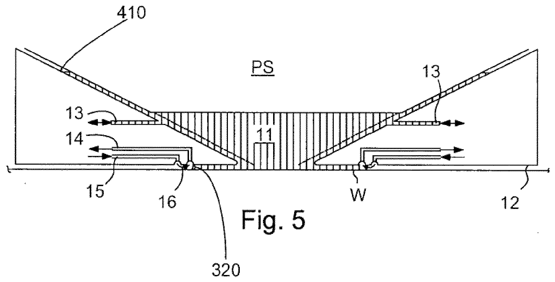

Another arrangement which has been proposed is to provide the liquid supply system with a liquid confinement structure which extends along at least a part of a boundary of the space between the final element of the projection system and the substrate table. Such an arrangement is illustrated in Figure 5.

Figure 5 schematically depicts a localized liquid supply system or liquid handling structure 12. The liquid handing structure 12 serves as a barrier, confining liquid to a localized surface of the underneath surface, such as of a substrate W, a substrate table WT or both. Within the meaning of the present invention, such a liquid supply structure may also be referred to as a barrier member. The liquid handling structure extends along at least a part of a boundary of the space between the final element of the projection system and the substrate table WT or substrate W. (Please note that reference in the following text to surface of the substrate W also refers in addition or in the alternative to a surface of the substrate table, unless expressly stated otherwise.) The liquid handling structure 12 is substantially stationary relative to the projection system in the XY plane though there may be some relative movement in the Z direction (in the direction of the optical axis). In an embodiment, a seal is formed between the liquid handling structure 12 and the surface of the substrate W. The seal may be a contactless seal such as a gas seal (such a system with a gas seal is disclosed in European patent application publication no. EP-A-1,420,298) or a liquid seal.

The liquid handling structure 12 at least partly contains liquid in the space 11 between a final element of the projection system PS and the substrate W. A contactless seal 16 to the substrate W may be formed around the image field of the projection system PS so that liquid is confined within the space between the substrate W surface and the final element of the projection system PS. The space 11 is at least partly formed by the liquid handling structure 12 positioned below and surrounding the final element of the projection system PS. Liquid is brought into the space below the projection system PS and within the liquid handling structure 12 by liquid inlet 13. The liquid may be removed by liquid outlet 13. The liquid handling structure 12 may extend a little above the final element of the projection system. The liquid level rises above the final element so that a buffer of liquid is provided. In an embodiment, the liquid handling structure 12 has an inner periphery that at the upper end closely conforms to the shape of the projection system or the final element thereof and may, e.g., be round. At the bottom, the inner periphery closely conforms to the shape of the image field, e.g., rectangular, though this need not be the case.

The liquid may be contained in the space 11 by a gas seal 16 which, during use, is formed between the bottom of the liquid handling structure 12 and the surface of the substrate W. The gas seal is formed by gas. The gas in the gas seal is provided under pressure via inlet 15 to the gap between the liquid handling structure 12 and substrate W. The gas is extracted via outlet 14. The overpressure on the gas inlet 15, vacuum level on the outlet 14 and geometry of the gap are arranged so that there is a high-velocity gas flow 16 inwardly that confines the liquid. The force of the gas on the liquid between the liquid handling structure 12 and the substrate W contains the liquid in a space 11. The inlets/outlets may be annular grooves which surround the space 11. The annular grooves may be continuous or discontinuous. The flow of gas 16 is effective to contain the liquid in the space 11. Such a system is disclosed in United States patent application publication no. US 2004-0207824, which is hereby incorporated by reference in its entirety. In an embodiment, the fluid handling structure 12 does not have a gas seal.

Another localized area arrangement is a liquid handling structure which makes use of a gas drag principle. The so-called gas drag principle has been described, for example, in United States patent application publication nos. US 2008-0212046, US 2009-0279060 and US 2009-0279062. In that system the extraction holes are arranged in a shape which may desirably have a corner. The cornered shape has at least one low radius part (i.e. at a corner) which has a first radius of curvature which is low relative to a second radius of curvature at a high radius part (i.e. a part between corners and/or distant from corners). The low radius part has a first radius of curvature which is lower than a second radius of curvature present at the high radius part. The second radius of curvature may be infinity i.e. the high radius part may be straight. The corner may be aligned with a preferred direction of movement, such as the stepping or the scanning direction. This reduces the force on the meniscus between two openings in the surface of the fluid handing structure for a given speed in the preferred direction compared to if the two outlets were aligned perpendicular to the preferred direction. However, an embodiment of the invention use a liquid handling system which in plan has any shape, or has a component such as the extraction openings arranged in any shape. Such a shape in a non-limiting list may include an ellipse such as a circle, a rectilinear shape such as a rectangle, e.g. a square, or a parallelogram such as a rhombus or a cornered shape with more than four corners such as a four or more pointed star.

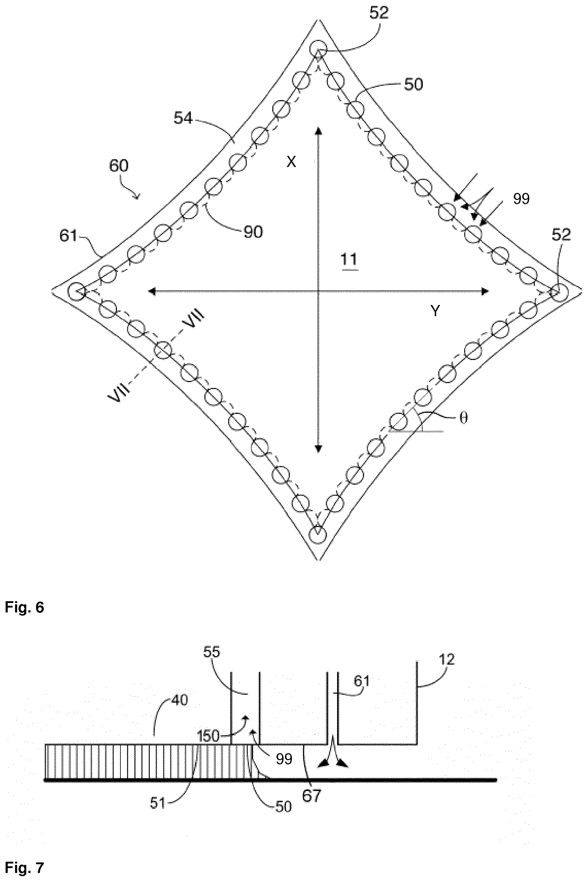

A plan view and a cross-sectional view of such barrier member or liquid handling system is schematically shown in Figures 6 and 7. Figures 6 and 7 illustrate the use of such a barrier member to contain an immersion liquid in a immersion lithographic apparatus. Such a barrier member that can be used in a clear-out tool according to the present invention to contain a liquid in a space next to or surrounding a target area. The barrier member comprises a meniscus pinning device comprising a plurality of meniscus pinning features 50 that may facilitate the containment of the liquid inside the space 11. The features of a meniscus pinning device are illustrated which may, for example, replace the arrangement 14, 15, 16 of FIG. 5. The meniscus pinning device of FIG. 6 comprises a plurality of discrete openings 50. Each of these openings 50 are illustrated as being circular though this is not necessarily the case. Indeed one or more of the openings 50 may be one or more selected from a circle, square, rectangular, oblong, triangular, an elongate slit, etc. Each opening has, in plan, a length dimension (i.e. in the direction from one opening to the adjacent opening) of greater than 0.2 mm, desirably greater than 0.5 mm or 1 mm, in an embodiment selected from the range of 0.1 mm to 10 mm, in an embodiment selected from the range of 0.25 mm to 2 mm. In an embodiment the length dimension is selected from the range of 0.2 mm to 0.5 mm, desirably the range of 0.2 mm to 0.3 mm. In an embodiment, the width of each opening is selected from the range of 0.1 mm to 2 mm. In an embodiment, the width of each opening is selected from the range of 0.2 mm to 1 mm

Each of the openings 50 of the meniscus pinning device of FIG. 6 may be connected to a separate under pressure source. Alternatively or additionally, each or a plurality of the openings 50 may be connected to a common chamber or manifold (which may be annular) which is itself held at an under pressure. In this way a uniform under pressure at each or a plurality of the openings 50 may be achieved. The openings 50 can be connected to a vacuum source and/or atmosphere surrounding the liquid handling structure or system (or barrier member or liquid supply system) may be increased in pressure to generate the desired pressure difference.

In the embodiment of FIG. 6 the openings are fluid extraction openings. That is they are inlets for the passage of gas and/or liquid into the fluid handling structure 12. That is, the inlets may be considered as outlets from the space 11.

The openings 50 are formed in a surface of the barrier member or fluid handling structure 12 . That surface faces the object, e.g. the substrate and/or substrate table, in use. In one embodiment the openings are in a flat surface of the barrier member. In another embodiment, a ridge may be present on the bottom surface of the barrier member. In that embodiment the openings may be in the ridge. In an embodiment, the openings 50 may be defined by needles or tubes. The bodies of some of the needles, e.g., adjacent needles, may be joined together. The needles may be joined together to form a single body. The single body may form the corner shape.

As can be seen from FIG. 7, the openings 50 are the end of a tube or elongate passageway 55, for example. Desirably the openings are positioned such that they face the substrate W in use. The rims (i.e. outlets out of a surface) of the openings 50 are substantially parallel to a top surface of the substrate W. The openings are directed, in use, towards the substrate and/or substrate table configured to support the substrate. Another way of thinking of this is that an elongate axis of the passageway 55 to which the opening 50 is connected is substantially perpendicularly (within +/-45°, desirably within 35 °, 25 ° or even 15 ° from perpendicular) to the top surface of the substrate W.

FIG. 7 illustrates that the opening 50 is provided in a bottom surface 40 of the fluid handling structure. This is however not necessarily the case and the openings 50 may be in a protrusion from the bottom surface of the fluid handling structure. Arrow 99 shows the flow of gas from outside of the fluid handling structure into the passageway 55 associated with the opening 50 and the arrow 150 illustrates the passage of liquid from the space into the opening 50. The passageway 55 and opening 50 are desirably designed so that two phase extraction (i.e. gas and liquid) desirably occurs in an annular flow mode in which gas substantially flows through the center of the passageway 55 and liquid substantially flows along the walls of the passageway 55. This results in smooth flow with low generation of pulsations.

Each opening 50 is designed to extract a mixture of liquid and gas. The liquid is extracted from the space 11 whereas the gas is extracted from the atmosphere on the other side of the openings 50 to the liquid. This creates a gas flow as illustrated by arrows 99 and this gas flow is effective to pin the meniscus 90 between the openings 50 substantially in place as illustrated in FIG. 6. The gas flow helps maintain the liquid confined by momentum blocking, by a gas flow induced pressure gradient and/or by drag (shear) of the gas flow on the liquid.

The openings 50 surround the space to which the fluid handling structure supplies liquid. That is, the openings 50 may be distributed in an undersurface of the fluid handling structure. The openings may be substantially continuously spaced around the space (although the spacing between adjacent openings 50 may vary). In an embodiment, liquid is extracted all the way around the closed shape, e.g. cornered shape, and is extracted substantially at the point at which it impinges on the cornered shape. This is achieved because the openings 50 are formed all the way around the space (in the cornered shape). In this way the liquid may be confined to the space 11. The meniscus may be pinned by the openings 50, during operation.

As can be seen from FIG. 6, the openings 50 are positioned so as to form, in plan, a cornered shape (i.e. a shape with corners 52). In the case of FIG. 6 this is in the shape of a square with curved edges or sides 54. The edges 54 have a negative radius. The edges 54 curve towards the center of the cornered shape in areas away from the corners 52.

The square has principal axes X, Y aligned with the major directions of travel of the substrate W under the projection system. This helps ensure that the maximum scan speed is faster than if the openings 50 were arranged in a circular shape. This is because the force on the meniscus between two openings 50 is reduced with a factor cos θ. Here θ is the angle of the line connecting the two openings 50 relative to the direction in which the substrate W is moving.

The use of a square shape allows movement in the step and scanning directions to be at a substantially equal maximum speed. This may be achieved by having each of the corners 52 of the shape aligned with the scanning and stepping directions X, Y. If movement in one of the directions, for example the scan direction is preferred to be faster than movement in the step direction then a rhombus shape could be used. In such an arrangement the primary axis of the rhombus may be aligned with the scan direction. For a rhombic shape, although each of the corners may be acute, the angle between two adjacent sides of the rhombus, for example in the stepping direction, may be obtuse, i.e. more than 90 ° (for example selected from the range of about 90 ° to 120 °, in an embodiment selected from the range of 90 ° and 105 °, in an embodiment selected from the range of 85 ° and 105°).

Throughput can be optimized by making the primary axis of the shape of the openings 50 aligned with the major direction of travel of the substrate (usually the scan direction) and to have a second axis aligned with the other major direction of travel of the substrate (usually the step direction). It will be appreciated that any arrangement in which 0 is different to 90 °. will give an advantage in at least one direction of movement. Thus, exact alignment of the principal axes with the major directions of travel is not vital.

An advantage of providing the edges with a negative radius is that the corners may be made sharper. An angle of selected from the range of 75 to 85 ° or even lower may be achievable for both the corners 52 aligned with the scan direction and the corners 52 aligned with the step direction. If it were not for this feature then in order for the corners 52 aligned in both directions to have the same angle, those corners would have to have 90 °. If less than 90 ° were desired it would be necessary to select one direction to have corners with less than 90 ° with the result that the other corner would have an angle of greater than 90 °.

As can be seen in FIG. 6, an aperture 61 is provided outside the openings 50. The aperture 61 may be substantially parallel to the lines joining the openings 50. The aperture 61 may be elongate and may be in the form of a slit. In an embodiment a series of discrete apertures 61 may be provided along a side 54 of the shape. In use, the elongate aperture 61 (or plurality of apertures 61) is connected to an over pressure source and forms a gas knife 60 surrounding the meniscus pinning system formed by openings 50.

The gas knife 60 in an embodiment of the invention functions to reduce the thickness of any liquid film left on the substrate or substrate table so that it does not break into droplets but rather the liquid is driven towards the openings 50 and extracted. In an embodiment the gas knife 60 operates to help prevent the formation of a film. To achieve this, it is desirable that the distance between the center lines of the gas knife and the meniscus pinning openings 50 is selected from the range of 1.5 mm to 4 mm, desirably from the range of 2 mm to 3 mm. The line along which apertures 61 (or elongate aperture 61) is arranged generally follows the line of the openings 50 so that the distance between adjacent ones of the apertures 61 (or elongate aperture 61) and openings 50 is within the aforementioned ranges. At a point on the line of openings, the direction of the line of apertures 61 (or elongate aperture 61) is parallel to the line of the openings 50. When the line of opening is a straight line, the line of openings 50 may be parallel to the line of apertures 61 (or elongate aperture 61). Where the line of openings 50 is curved, the line of apertures 61 (or elongate aperture 61) may be curved. The line of openings and the line of apertures 61 (or elongate aperture 61) may form the outline of similar shapes of dissimilar size. It is desirable to maintain a constant separation between adjacent ones of the apertures 61 (or elongate aperture 61) and openings 50. In an embodiment this is desirable along the length of each center line of the gas knife. In an embodiment the constant separation may be in the region of one of more corners of the fluid handling, device.

The gas knife is desirably close enough to the openings 50 to create a pressure gradient across the space between them. There is desirably no stagnant zone in which a layer of liquid, or liquid droplets can accumulate. In an embodiment, the continuous lower surface of barrier member 12 forms a damper 67 which assists in creating the pressure gradient. The lower surface is desirable substantially parallel to the opposing surface of the substrate or substrate table. In an embodiment, the presence of the damper allows the openings 50 to be arranged in a different or dissimilar shape from that of the gas knife apertures 61 (or elongate aperture 61). For example, the shape formed by the openings 50 may be a star and the apertures 61 (or elongate aperture 61) of the gas knife may form a square. In an embodiment the gas knife apertures 61 (or elongate aperture 61) may form an ellipse, having its major and minor axes of different lengths, and the openings 50 may form a circle.

In an embodiment, the present invention provides in a clear-out tool, which can be used to, at least partly, to remove a layer that is provided on a target area of an object such as a substrate. Within the meaning of the present invention 'clear-out' refers to the process of clearing or removing at least part of a masking layer from a target area. The clear-out tool according to the present invention makes use of a liquid handling system, further on referred to as a barrier member, to contain a liquid in a space surrounding the target area or next to the target area.

In the clear-out tool according to the present invention, the liquid that is contained by the barrier member is applied to either clean the object during or after a laser ablation process or to mitigate the distribution of the debris that is generated during such ablation process.

In order to accurately project a patterned beam of radiation onto a substrate, a position of the substrate, in particular a position of previously projected patterns should be accurately known. In order to determine such position, use is often made of markings or marks that are projected onto the substrate. When a position of such marks is measured, these measurements can be used to control a positioning of a substrate table, e.g. substrate table WT shown in Figure 1, relative to the patterned radiation beam, aligning the patterned beam of radiation with a previously projected pattern. Such marks are therefor often referred to as alignment marks.

Prior to the projection of the patterned beam of radiation, the top surface of the substrate is covered with a resist layer or mask, onto which the pattern is projected.

Such a resist layer or hard mask may obscure the alignment marks on the substrate as well, thus making a measurement of the position of such alignment marks somewhat difficult, e.g. in case the measurement beam of an alignment sensor used cannot or can only partially penetrate the resist layer.

In order to mitigate this, the present invention provides in a clear-out tool that may be applied to remove or partially remove such a resist layer or mask, in particular at locations or areas where the alignment marks are present.

Clear-out tools are known in general and may be used to remove material from a solid surface by irradiating it with a laser beam. During such a process, debris will be generated due to the removal of material.

Inside a lithographic exposure apparatus, there are stringent conditions with respect to contamination. The environment where the exposure or measurement process takes place needs to be substantially free of contaminants. As such, a substrate that has been subjected to a laser ablation process in a clear-out tool needs to be free of contaminants. So, even in case the clear-out tool is a stand alone tool, care should be taken to ensure that a substrate leaving the tool is free of contaminants and/or care should be taken that the tool itself does not become contaminated since such contamination could end up on processed substrates prior to them being exported outside the tool.

In view of this, the present invention provides in a clear-out tool that enables the removal or partial removal of a masking layer and facilitates a removal of debris that is generated by the ablation process. Such a clear-out tool may be embodied as a stand alone tool or system or may be incorporated in a lithographic apparatus.

In an embodiment, the clear-out tool comprises a barrier member that is configured to contain a liquid above a target area, i.e. an area targeted by a laser beam. By doing so, any debris or particles that are generated by the ablation process may be contained more easily. An effective way to stop or mitigate the spreading of particles or debris is to rely on the drag force experienced when a particle moves through a liquid. This drag force is proportional to the viscosity of the liquid. As such, when the target area of a laser ablation beam is immersed in a liquid such as water, the generated particles will be easily stopped and contained in the liquid. This manner of stopping particles from spreading is more effective than the use of air as a medium to stop particles.

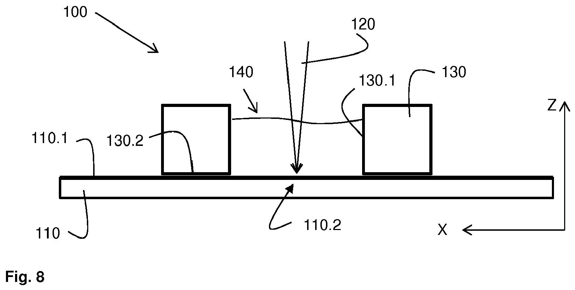

Figure 8 schematically shows a first embodiment of a clear-out tool 100 according to the present invention. Figure 8 schematically shows a cross-sectional view of an object 110, e.g. a semiconductor substrate, provided with a layer 110.1, e.g. a masking layer such as a resist layer or mask. In the embodiment as shown, the clear-out tool 100 is configured to at least partially remove a masking layer from a target area 110.1 of an object 110 such as a substrate. This target area can be considered an area on the object where the masking layer needs to be removed or partially removed. In an embodiment, this can be realised by using a laser beam, in particular by projecting a laser beam 120 onto the target area 110.2 of the object 100. In the embodiment as shown, the clear-out tool further comprises a barrier member 130 configured to contain a liquid 140. In the embodiment as shown, the barrier member 130 is configured to contain the liquid 140 in a space above the target area, in particular a space that borders on the target area 110.2. In the embodiment as shown, the space is bound by a surface 130.1 of the barrier member and a top surface of the object including the target area 110.2. In order to contain the liquid in the space, the barrier member may be provided with one more seals to seal a gap between the top surface of the object, i.e. the surface provided with the masking layer 110.1, and a bottom surface 130.2 of the barrier member. Such a seal may e.g. be a contactless seal such as a gas knife, as explained above and as will be explained in more detail below.

In an embodiment, the liquid as applied has a larger viscosity than air. By doing so, particles generated by the ablation process will be stopped inside the liquid. In such an embodiment, due to the surface tension of the liquid, the particles will remain trapped inside the liquid.

In an embodiment, the barrier member may have an annular shape or may be frame shaped, e.g. square or rectangular.

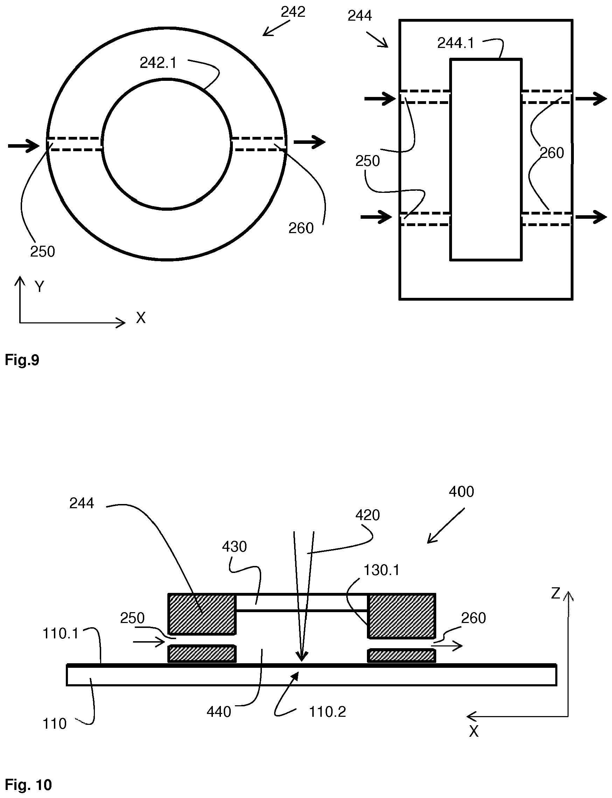

Figure 9 schematically shows a top view of such barrier members.

Figure 9 schematically depicts two possible cross-sectional views of barrier members 242, 244 as can be applied in a clear-out tool according to the present invention. The barrier member 242 on the left has an annular cross-section, whereas the barrier member 244 on the right has a frame-shaped cross-section. In the embodiments as shown, the barrier members 242, 244 further comprise one or more inlets 250 and one or more outlets 260, the liquid flow being indicated by the arrows. The inlets 250 may e.g. be configured to provide a liquid to the space bound by an inner surface of the barrier members, e.g. inner surfaces 242.1 and 244.1. The outlets 260 may e.g. be configured to vacate the liquid from the space, together with any debris that is generated during the laser ablation process. In an embodiment, a substantially continuous supply and removal of the liquid is provided via the inlet(s) and outlet(s). As such, the liquid may be continuously refreshed and the debris removed along with the liquid.

Figure 10 schematically shows an XZ cross-sectional view of a clear-out tool 400 according to the present invention, the clear-out tool 400 comprising the barrier member 244 of Figure 9. The cross-section is selected in such manner so as to include an inlet and an outlet.

Figure 10 schematically shows another clear-out tool 400 according to the present invention, the clear-out tool 400 comprising the barrier member 244 for containing a liquid 440 into a space above a target area 110.2 of a laser beam 420 provided by the clear-out tool 400. In the embodiment as shown, the barrier member 244 is further equipped with a cover 430 enabling to contain the liquid 440 more easily. Such a cover 430 may be made of a material that is transparent to the wavelength of the applied laser beam 420. In an embodiment, the cover 430 may be part of the optical design of the clear-out tool or a laser of the clear-out tool, it may e.g. be a focussing lens. The barrier member 244 further comprises an inlet 250 configured to provide a liquid, e.g. water, to the space above the target area 110.2, and an outlet 260 configured to vacate or remove the liquid from the space, together with any debris or particles that are generated.

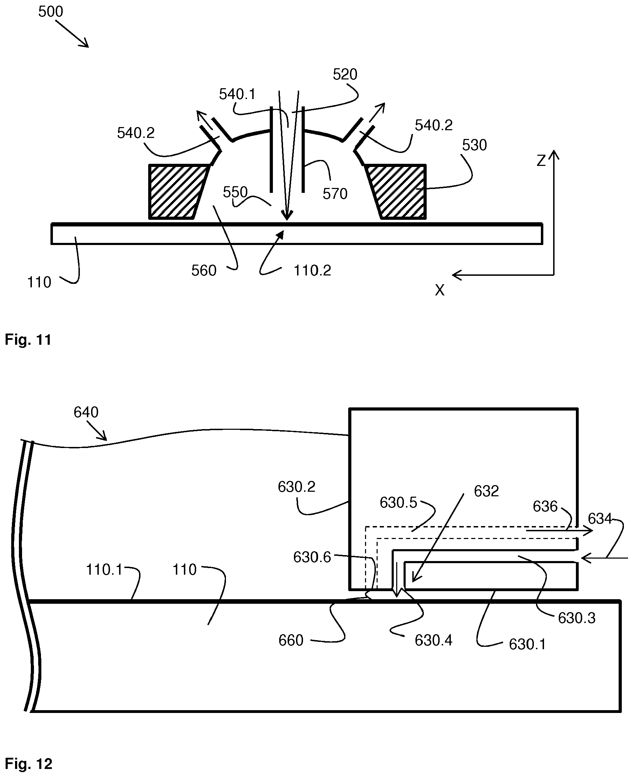

Figure 11 schematically shows yet another clear-out tool 500 according to an embodiment of the present invention.

The clear-out tool 500 as schematically shown comprises a barrier member 530 which has a dome-shaped cover 540 having a central aperture 540.1 which serves as an inlet for a liquid, indicated by the arrows 550 into the space 560 underneath the cover. In the embodiment as shown, the central aperture 540.1 is also used to enable a laser beam 520 to be projected onto a target area 110.2 of an object, e.g. to remove part of a masking layer provided on the object 110. In the embodiment as shown, the cover 540 further comprises two outlets 540.2 via which the liquid, together with any debris from during the ablation process of the masking layer can be removed. In the embodiment as shown, a tubular shaped section 570, extending in a direction substantially perpendicular to a bottom surface 530.1 of the barrier member 530, is provided in the central aperture 540.1, for guiding the liquid downwards in a direction of the target area. By doing so, a rinsing and removal of debris from the target area may be facilitated.

Figure 12 schematically shows a possible contactless seal that can be applied in a clear-out tool according to the present invention to contain a liquid.

Figure 12 schematically shows a cross-sectional view of a portion of a barrier member 630 as can be applied in a clear-out tool according to the present invention. The barrier member 630 as shown as a bottom surface 630.1 that faces a top surface 110.1 of an object 110, e.g. semiconductor substrate provided with a masking layer. In accordance with an embodiment of the present invention, the barrier member is configured to contain a liquid 640, e.g. water, in a space above the object. In the arrangement as shown, the space containing the liquid 640 is bound by a surface 630.2 of the barrier member 630 and the top surface 110.1. In the embodiment as shown, the bottom surface 630.1 of the barrier member 630 does not contact the object 110. In order to contain the liquid 640 in the space indicated, a gas seal 632 is provided. In the embodiment as shown, the barrier member 630 comprises a conduit 630.3 enabling to supply a gas flow 634 towards an outlet 630.4 provided in the bottom surface 630.1 of the barrier member. The gas flow 634 may serve as a gas knife in a similar manner as gas knife 60 discussed above. Due to the supplied gas, a pressure can be build in the gap between the bottom surface 630.1 of the barrier member 630 and the top surface 110.1 of the object. By doing so, the liquid 640 can be contained in the space, as indicated by the meniscus 660 of the liquid. in an embodiment, the barrier member may be provided with a plurality of outlets 640.4 in the bottom surface 630.3, e.g. distributed around the space. In addition to a conduit 630.3 for supplying the gas flow 634, the barrier member 630 may also include a conduit 630.5 serving to extract liquid or a liquid/gas mixture from the space (indicated by the arrow 636), via one or more extraction holes 630.6. Note that these extraction holes may e.g. be arranged and shaped in a similar manner as extraction holes 50 described above. These extraction holes 630.6 may also serve as meniscus pinning features for pinning the meniscus 660.

In the embodiments shown in Figures 8 to 12, the clear-out tool according to the present invention comprises a barrier member that is configured to contain a liquid in a space that borders on a target area for a laser beam, i.e. in a space above the target area for a laser beam.

In an embodiment, said liquid may e.g. be water. Alternatively, the liquid applied may comprise a reactive substance, reacting with the debris that is generated. in such an embodiment, the reactive substance may, at least partly dissolve the debris that is generated. it may be pointed out that the masking layer may be affected by the solution as well. However, due to the comparatively large surface area of the debris particles, the debris may dissolve in the solution prior to the masking layer being adversely affected.

In yet another embodiment of the present invention, the clear-out tool is configured to contain a liquid in a space that surrounds a target area for a laser beam.

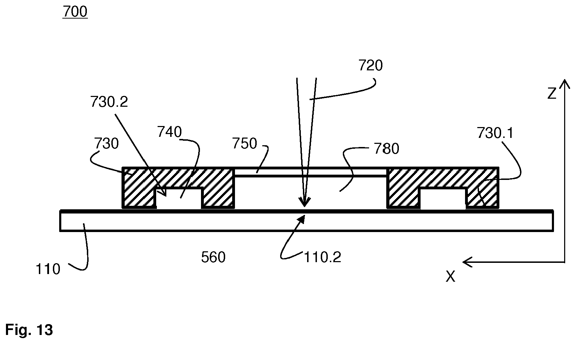

Such an embodiment is schematically shown in Figure 13.

Figure 13 schematically shows a cross-sectional view of an embodiment of a clear-out tool 700 according to the present invention. The embodiment as shown comprises a barrier member 730 that is configured to contain a liquid 740 in a space surrounding a target area 110.2 of a laser beam 720 of the clear-out tool 700. In the embodiment as shown, the barrier member 730 comprises, in a bottom surface 730.1 of the barrier member 730, a cavity or space 730.2 having a rectangular cross-section, whereby the cavity 730.2 can be filled with a liquid 740. Note that the cross-section need not be rectangular, other cross-section shapes may be considered as well. In the embodiment as shown, the barrier member 730 further comprises a cover 750, that is configured to be substantially transparent to laser beam 720. In an embodiment, the cover 750 may be part of the optical design of the laser or ablation tool, it may e.g. be a focussing lens. In such an embodiment, the barrier member 730 may e.g. be configured to contain a conditioned atmosphere in a space 780 above the target area 110.2. Such a conditioned atmosphere may e.g. be a low pressure atmosphere or even vacuum.

Alternatively, the space 780 may be filled with a liquid such as a reactive substance which can dissolve the debris that is generated.

When applying the clear-out tool 700 as shown in Figure 13, the liquid 740 kept in the space 730.2 surrounding the target area 110.2 can be used to clean the target area 110.2 by displacing the object 110 relative to the barrier member in a plane substantially parallel to the surface of the object, until the liquid 740 contacts the target area. By doing so, the debris on the surface of the object may be rinsed away.

In order to provide the required atmosphere inside the space 780 or to provide the desired liquid 740 inside the space surrounding the target area, the barrier member may be provided with the required inlets and outlets, in a similar manner as discussed with reference to Figures 9 and 10. As such, in an embodiment, the clear-out tool may e.g. comprise an inlet configured to providing the liquid into the space 730.2, an outlet configured to vacate the liquid and debris generated by the laser ablation from the space 730.2, a further inlet configured to providing the reactive substance into the space 780, and a further outlet configured to vacate the reactive substance and debris generated by the laser ablation from the space 780.

In order to contain the liquid in the space 730.2 and the liquid in the space 780, seals may be provided to seal the gap between the bottom surface 730.1 of the barrier member and the object 110.

Such a seal or seals may be comparable to the seal 632 as schematically shown in Figures 7 or 12.

In an embodiment, the clear-out tool according to the present invention comprises, as the barrier member, a liquid supply system such as liquid supply system 12 as shown in Figure 5 or Figures 6 and 7.

In an embodiment, the clear-out tool according to the invention comprises a laser or laser source for generating the laser beam that is applied to the target area.
Possible embodiments for such a laser include UltraShortPulsed (USP) laser types. Examples of such lasers are 10 ps (picosecond) lasers or 400 fs (femtosecond) lasers. Such a 10 ps laser may e.g. be applied with an average power < 50 mW and a repetition rate of up to 8 Mhz for the laser clear-out process or laser ablation process. A wavelength of 532 nm (green) or 1064 nm (IR) may e.g. be applied.

In an embodiment, the clear-out tool according to the invention further comprises a stage positioning system comprising an object table onto which the object, e.g. object 110 as shown, can be mounted and a positioning device configured to position the object table relative to the laser ablation beam.

Such a positioning device may e.g. comprises one or more motors or actuators, e.g. electromagnetic motors or actuators for positioning the object table relative to the laser beam.

In such an arrangement, either the object table or the laser beam may be displaced or positioned. In the latter case, lenses and/or mirrors may be applied to redirect the laser beam to the appropriate target area, whereby the lenses and/or mirrors are actuated by actuators such as electromagnetic actuators or piezoelectric actuators. In the former case, the object table may be mounted to a positioning device or positioner comprising a long stroke positioner, configured for coarse positioning of the object table over comparatively large distances, and a short stroke positioner, configured for fine positioning of the object table over comparatively short distances. Such a positioner may e.g. be comparable to the position PW as discussed above. The clear-out tool according to the present invention may advantageously be used to remove or partially remove a resist layer or mask, in particular at locations or areas where alignment marks are present. By doing so, the alignment marks, e.g. present in a layer that is covered by the resist layer or mask may be, at least partly, uncovered, thus facilitating the detection of such marks, in particular the position of such marks, by an alignment sensor of a lithographic apparatus. As such, the clear-out tool according to the present invention may advantageously be combined with a lithographic apparatus.

Therefore, in an embodiment, the present invention provides in a lithographic system comprising a lithographic apparatus and a clear-out tool according to the present invention. In such a system, a substrate that is provided with a masking layer such as a resist layer may be received by the clear-out tool in order to at least partly remove the masking layer from a target area or target areas on the object. Such target area or target areas may e.g. be areas on the substrate where alignment marks are provided in a layer that is covered by the masking layer. As such, when the masking layer has been, at least partly, removed from the target area or areas, a detection of the alignment marks may be facilitated. As such, a substrate that has been processed by the clear-out tool of the lithographic system may then be transferred to the lithographic apparatus of the lithographic system. In an embodiment, the lithographic apparatus may be configured to determine a position of the alignment marks present below the target area or areas. These alignment mark positions may then be used to accurately align the substrate, with a patterned beam of radiation of the lithographic apparatus. In particular, the alignment mark positions may be used to align the target portions C of the substrate, as discussed with reference to Figure 1, with the patterned beam of radiation.

In an embodiment, the clear-out tool may be integrated in a lithographic apparatus. In such embodiment, the lithographic apparatus may comprise a positioning device or positioner, such as positioner PW discussed above, whereby the positioner is configured to position a substrate table holding a substrate sequentially in an operating range of the clear-out tool, in an operating range of an alignment sensor of the lithographic apparatus and in an operating range of the projection system. In an embodiment, a lithographic apparatus, in particular an immersion lithographic apparatus may be configured to operate as a clear-out tool according to the present invention. In such embodiment, the present invention provides in a lithographic apparatus comprising:
- an illumination system configured to condition a radiation beam;
- a support constructed to support a patterning device, the patterning device being capable of imparting the radiation beam with a pattern in its cross-section to form a patterned radiation beam
- a substrate table constructed to hold a substrate; and
- a projection system configured to project the patterned radiation beam onto a target portion of the substrate,
a liquid handling system for containing a liquid in a space between a final element of the projection system and the substrate, and wherein the apparatus is configured to at least partially remove a masking layer from a target area of the substrate by projecting a laser beam via the projection system onto the target area, the liquid handling system being configured to contain the liquid in a space next to the target area or surrounding the target area.

In such embodiment, the projection system of the lithographic apparatus may thus be applied to project a laser beam onto a target area of a substrate, while the liquid handling system of the apparatus serves a barrier member to contain the liquid in a space next to the target area or surrounding the target area.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm). The term "lens", where the context allows, may refer to any one or combination of various types of optical components, including refractive and reflective optical components.

While specific embodiments of the invention have been described above, it will be appreciated that the invention, at least in the form a method as herein described, may be practiced otherwise than as described. For example, the embodiments of the invention, at least in the form of a method, may take the form of a computer program containing one or more sequences of machine-readable instructions describing a method as disclosed above, or a data storage medium (e.g. semiconductor memory, magnetic or optical disk) having such a computer program stored therein. Further, the machine readable instruction may be embodied in two or more computer programs. The two or more computer programs may be stored on one or more different memories and/or data storage media.

Any controllers described herein may each or in combination be operable when the one or more computer programs are read by one or more computer processors located within at least one component of the lithographic apparatus. The controllers may each or in combination have any suitable configuration for receiving, processing, and sending signals. One or more processors are configured to communicate with the at least one of the controllers. For example, each controller may include one or more processors for executing the computer programs that include machine-readable instructions for the methods described above. The controllers may include data storage medium for storing such computer programs, and/or hardware to receive such medium. So the controller(s) may operate according the machine readable instructions of one or more computer programs.

An embodiment of the invention may be applied to substrates with a diameter of 300 mm or 450 mm or any other size.

A liquid supply system as contemplated herein should be broadly construed. In certain embodiments, it may be a mechanism or combination of structures that provides a liquid to a space between the projection system and the substrate and/or substrate table. It may comprise a combination of one or more structures, one or more fluid openings including one or more liquid openings, one or more gas openings or one or more openings for two phase flow. The openings may each be an inlet into the immersion space (or an outlet from a fluid handling structure) or an outlet out of the immersion space (or an inlet into the fluid handling structure). In an embodiment, a surface of the space may be a portion of the substrate and/or substrate table, or a surface of the space may completely cover a surface of the substrate and/or substrate table, or the space may envelop the substrate and/or substrate table. The liquid supply system may optionally further include one or more elements to control the position, quantity, quality, shape, flow rate or any other features of the liquid.

In an embodiment, the lithographic apparatus is a multi-stage apparatus comprising two or more tables located at the exposure side of the projection system, each table comprising and/or holding one or more objects. In an embodiment, one or more of the tables may hold a radiation-sensitive substrate. In an embodiment, one or more of the tables may hold a sensor to measure radiation from the projection system. In an embodiment, the multi-stage apparatus comprises a first table configured to hold a radiation-sensitive substrate (i.e., a substrate table) and a second table not configured to hold a radiation-sensitive substrate (referred to hereinafter generally, and without limitation, as a measurement and/or cleaning table).The second table may comprise and/or may hold one or more objects, other than a radiation-sensitive substrate. Such one or more objects may include one or more selected from the following: a sensor to measure radiation from the projection system, one or more alignment marks, and/or a cleaning device (to clean, e.g., the liquid confinement structure).

In an embodiment, the lithographic apparatus may comprise an encoder system to measure the position, velocity, etc. of a component of the apparatus. In an embodiment, the component comprises a substrate table. In an embodiment, the component comprises a measurement and/or cleaning table. The encoder system may be in addition to or an alternative to the interferometer system described herein for the tables. The encoder system comprises a sensor, transducer or readhead associated, e.g., paired, with a scale or grid. In an embodiment, the movable component (e.g., the substrate table and/or the measurement and/or cleaning table) has one or more scales or grids and a frame of the lithographic apparatus with respect to which the component moves has one or more of sensors, transducers or readheads. The one or more of sensors, transducers or readheads cooperate with the scale(s) or grid(s) to determine the position, velocity, etc. of the component. In an embodiment, a frame of the lithographic apparatus with respect to which a component moves has one or more scales or grids and the movable component (e.g., the substrate table and/or the measurement and/or cleaning table) has one or more of sensors, transducers or readheads that cooperate with the scale(s) or grid(s) to determine the position, velocity, etc. of the component.

In an embodiment, the lithographic apparatus comprises a liquid confinement structure that has a liquid removal device (or meniscus pinning feature) having an inlet covered with a mesh or similar porous material. The mesh or similar porous material provides a two-dimensional array of holes contacting the immersion liquid in a space between the final element of the projection system and a movable table (e.g., the substrate table). In an embodiment, the mesh or similar porous material comprises a honeycomb or other polygonal mesh. In an embodiment, the mesh or similar porous material comprises a metal mesh. In an embodiment, the mesh or similar porous material extends all the way around the image field of the projection system of the lithographic apparatus. In an embodiment, the mesh or similar porous material is located on a bottom surface of the liquid confinement structure and has a surface facing towards the table. In an embodiment, the mesh or similar porous material has at least a portion of its bottom surface generally parallel with a top surface of the table.

The embodiments may further be described using the following clauses:
1. A clear-out tool configured to at least partially remove a masking layer from a target area of an object using a laser beam, the clear-out tool comprising a barrier member configured to contain a liquid in a space next to the target area or surrounding the target area.
2. The clear-out tool according to clause 1, further comprising a laser configured to project the laser beam onto the target area for at least partly removing the masking layer from the target area by means of a laser ablation process.
3. The clear-out tool according to clause 2, wherein the barrier member comprises:
   an inlet configured to providing the liquid into the space and
   an outlet configured to vacate the liquid and debris generated by the laser ablation process from the space.
4. The clear-out tool according to clause 3, wherein the liquid comprises water.
5. The clear-out tool according to clause 3 or 4, wherein the tool is configured to substantially continuously provide the liquid into the space and vacate the liquid and debris from the space, during the laser ablation process.
6. The clear-out tool according to any of the clauses 1 to 5, wherein the barrier member comprises a cover that is transparent to the laser beam.
7. The clear-out tool according to any of the preceding clauses, wherein the barrier member comprises a bottom surface substantially parallel to a top surface of the object.
8. The clear-out tool according to clause 5, wherein a bottom surface of the barrier member comprises a gas outlet configured to provide a gas flow towards the top surface, the gas flow being configured to contain the liquid in the space.
9. The clear-out tool according to any of the preceding clauses, wherein the liquid has a higher viscosity than air.
10. The clear-out tool according to any of the preceding clauses, wherein the barrier member has a tubular inlet for providing the liquid into the space.
11. The clear-out tool according to clause 10, wherein the tubular inlet extends in a direction substantially perpendicular to a bottom surface of the barrier member.
12. The clear-out tool according to clause 10 or 11, wherein the laser beam is projected onto the target area through the tubular inlet.
13. The clear-out tool according to clause 1, where the barrier member is configured to contain the liquid in the space surrounding the target area and is configured to contain a conditioned atmosphere in a further space above the target area.
14. The clear-out tool according to clause 13, wherein the conditioned atmosphere comprises a low pressure atmosphere or vacuum.
15. The clear-out tool according to clause 13, wherein the conditioned atmosphere comprises a reactive substance.
16. The clear-out tool according to clause 15, where the barrier member comprises:
   an inlet configured to providing the liquid into the space;
   an outlet configured to vacate the liquid and debris generated by a laser ablation process from the space;
   a further inlet configured to providing the reactive substance into the further space, and
   a further outlet configured to vacate the reactive substance and debris generated by the laser ablation process from the further space.
17. The clear-out tool according to any of the preceding clauses, further comprising an object table configured to hold the object.
18. The clear-out tool according to clause 17, further comprising a positioning device configured to position the object table relative to the laser beam.
19. The clear-out tool according to any of the preceding clauses, wherein the laser beam is an ultra-short pulsed laser beam.
20. A lithographic apparatus comprising:
   an illumination system configured to condition a radiation beam;
   a support constructed to support a patterning device, the patterning device being capable of imparting the radiation beam with a pattern in its cross-section to form a patterned radiation beam a substrate table constructed to hold a substrate; and
   a projection system configured to project the patterned radiation beam onto a target portion of the substrate,
   wherein the apparatus further comprises a clear-out tool according to any of the clauses 1 to 19.
21. The lithographic apparatus according to clause 20, further comprising a liquid handling system for containing an immersion liquid in a space between a final element of the projection system and the substrate.
22. A lithographic apparatus comprising:
   an illumination system configured to condition a radiation beam;
   a support constructed to support a patterning device, the patterning device being capable of imparting the radiation beam with a pattern in its cross-section to form a patterned radiation beam;
   a substrate table constructed to hold a substrate; and
   a projection system configured to project the patterned radiation beam onto a target portion of the substrate,
   a liquid handling system for containing a liquid in a space between a final element of the projection system and the substrate, and wherein the apparatus is configured to at least partially remove a masking layer from a target area of the substrate by projecting a laser beam via the projection system onto the target area, the liquid handling system being configured to contain the liquid in a space next to the target area or surrounding the target area.
23. A device manufacturing method comprising projecting a patterned beam of radiation onto a substrate, wherein the step of projecting a patterned beam of radiation onto a substrate is applied before or after a step of at least partly removing a masking layer from a target area on the substrate using a clear-out tool according to any of the clauses 1 to 19.

The descriptions above are intended to be illustrative, not limiting. Thus, it will be apparent to one skilled in the art that modifications may be made to the invention as described without departing from the scope of the claims set out below.

## Claims

1. A clear-out tool configured to at least partially remove a masking layer from a target area of an object using a laser beam, the clear-out tool comprising a barrier member configured to contain a liquid in a space next to the target area or surrounding the target area.

2. The clear-out tool according to claim 1, further comprising a laser configured to project the laser beam onto the target area for at least partly removing the masking layer from the target area by means of a laser ablation process.

3. The clear-out tool according to claim 2, wherein the barrier member comprises:
- an inlet configured to providing the liquid into the space and
- an outlet configured to vacate the liquid and debris generated by the laser ablation process from the space.

4. The clear-out tool according to claim 3, wherein the liquid comprises water.

5. The clear-out tool according to claim 3 or 4, wherein the tool is configured to substantially continuously provide the liquid into the space and vacate the liquid and debris from the space, during the laser ablation process.

6. The clear-out tool according to any of the claims 1 to 5, wherein the barrier member comprises a cover that is transparent to the laser beam.

7. The clear-out tool according to any of the preceding claims, wherein the liquid has a higher viscosity than air.

8. The clear-out tool according to any of the preceding claims, wherein the barrier member has a tubular inlet for providing the liquid into the space, and wherein the tubular inlet extends in a direction substantially perpendicular to a bottom surface of the barrier member.

9. The clear-out tool according to claim 8, wherein the laser beam is projected onto the target area through the tubular inlet.

10. The clear-out tool according to claim 1, where the barrier member is configured to contain the liquid in the space surrounding the target area and is configured to contain a conditioned atmosphere in a further space above the target area.

11. The clear-out tool according to claim 10, wherein the conditioned atmosphere comprises a low pressure atmosphere or vacuum, or wherein the conditioned atmosphere comprises a reactive substance.

12. The clear-out tool according to claim 11, where the barrier member comprises:
- an inlet configured to providing the liquid into the space;
- an outlet configured to vacate the liquid and debris generated by a laser ablation process from the space;
- a further inlet configured to providing the reactive substance into the further space, and
- a further outlet configured to vacate the reactive substance and debris generated by the laser ablation process from the further space.

13. The clear-out tool according to any of the preceding claims, further comprising an object table configured to hold the object.

14. A lithographic apparatus comprising:
- an illumination system configured to condition a radiation beam;
- a support constructed to support a patterning device, the patterning device being capable of imparting the radiation beam with a pattern in its cross-section to form a patterned radiation beam
- a substrate table constructed to hold a substrate; and
- a projection system configured to project the patterned radiation beam onto a target portion of the substrate,
wherein the apparatus further comprises a clear-out tool according to any of the claims 1 to 13.

15. A device manufacturing method comprising projecting a patterned beam of radiation onto a substrate, wherein the step of projecting a patterned beam of radiation onto a substrate is applied before or after a step of at least partly removing a masking layer from a target area on the substrate using a clear-out tool according to any of the claims 1 to 13.
